# EUROPEAN PATENT APPLICATION

(11) **EP 4 657 080 A1**
(43) Date of publication of application: **03.12.2025**
(21) Application number: 25178963.2
(22) Date of filing: 27.05.2025
(51) Int. Cl.: G01R 1/04, G01R 31/12, G01R 1/18

(54) **CONNECTION JIG, CHAMBER-WITH-JIG, AND WITHSTAND VOLTAGE TEST DEVICE**

(30) Priority: 27.05.2024 JP 2024085407
(71) Applicant: Espec Corp., Kita-ku Osaka-shi Osaka 530-8550 (JP)
(72) Inventor: TOKUNAGA, Yuta, Osaka, 530-8550 (JP)
(74) Representative: SSM Sandmair

(57) **Abstract**

A connection jig includes: a holding portion made of an electrically insulating material that holds a first connector portion; a regulation portion disposed at a position spaced apart from the holding portion and made of an electrically insulating material; an electromagnetic shield having a size conforming to a hole formed in a wall body of a test chamber and disposed so as to cover a gap space between the holding portion and the regulation portion; and a conductor connected to the first connector portion and including a portion disposed in the gap space. The conductor is connected to a second connector portion fixed to the regulation portion.

## Description

### Field of the Invention

The present invention relates to a connection jig, a chamber-with-jig, and a withstand voltage test device.

### Background Art

Conventionally, in electrical products, electrical components, semiconductor components, and the like, there has been known a withstand voltage test device for checking whether there is sufficient dielectric strength with respect to a use voltage, that is, whether dielectric breakdown is not caused, or for measuring insulation resistance. The withstand voltage test device includes a withstand voltage test chamber, a power supply unit that generates a high voltage (for example, a high voltage of 1 kV or more), and wiring that connects the power supply unit and a test piece to each other. The withstand voltage test device is configured to apply a high voltage from the power supply unit to the test piece disposed in the withstand voltage test chamber. The test can be accelerated by performing a test of applying a high voltage to the test piece in a state where the test piece is exposed to a high temperature. The wiring is drawn into the chamber through a cable hole provided in the withstand voltage test chamber.

In a case where the wiring is passed through the cable hole of the chamber, it may be possible to use a cable connection jig 80 disclosed in JP 2014-163718 A. As illustrated in Fig. 15, the cable connection jig 80 includes an outer terminal block 81 provided with an outer terminal 81a to which external wiring can be connected, an inner terminal block 82 provided with an inner terminal 82a to which in-chamber wiring can be connected, and a connector unit 85 inserted into a cable hole 84 of the chamber and electrically connecting both the terminals 81a and 82a.

The cable connection jig 80 disclosed in JP 2014-163718 A only needs to connect the in-chamber wiring to the inner terminal 82a while connecting the external wiring to the outer terminal 81a, so that it is possible to avoid work for inserting the wiring into the cable hole 84. Therefore, the burden of the wire connection work can be reduced. However, since the cable connection jig 80 of JP 2014-163718 A is a jig provided in a test device that performs an environmental test of a test piece, measures against high voltage as performed in a withstand voltage test are not taken.

### Summary of the Invention

An object of the present invention is to avoid noise leakage from a hole of a test chamber in a case where a high voltage load is applied, and to suppress discharge in the hole of the test chamber.

A connection jig according to one aspect of the present invention is a connection jig used in a test chamber, the connection jig including: a holding portion holding a connector portion and made of an electrically insulating material; a regulation portion disposed at a position spaced apart from the holding portion and made of an electrically insulating material; an electromagnetic shield having a size conforming to a hole formed in a wall body of the test chamber and disposed so as to cover a space between the holding portion and the regulation portion; and a conductor connected to the connector portion and including a portion disposed in the space. The conductor is connected to a connector portion fixed to the regulation portion, or is drawn out to an outside of the regulation portion through the regulation portion in a state where a position of the conductor with respect to the electromagnetic shield is regulated.

A chamber-with-jig according to another aspect of the present invention includes the connection jig and a test chamber, and a hole into which an electromagnetic shield of the connection jig is inserted is formed in a wall body of the test chamber.

A withstand voltage test device according to another aspect of the present invention includes the chamber-with-jig, and a power supply unit configured to be capable of applying a voltage to the conductor.

### Brief Description of the Drawings

Fig. 1 is a diagram schematically illustrating a withstand voltage test device according to a first embodiment.
Fig. 2 is a diagram illustrating a configuration of a connection jig included in the withstand voltage test device.
Fig. 3 is a diagram illustrating the connection jig in a state of being viewed from a holding portion side.
Fig. 4 is a diagram illustrating the connection jig in a state before first and second connector portions, a conductor, and an electromagnetic shield are assembled.
Fig. 5 is a diagram illustrating a state in which the conductor is assembled.
Fig. 6 is a cross-sectional view of a holding portion taken along line VI-VI in Fig. 3.
Fig. 7 is a cross-sectional view of the holding portion taken along line VII-VII of Fig. 3.
Fig. 8 is a diagram illustrating the connection jig in a state of being viewed from a regulation portion side.
Fig. 9 is a cross-sectional view of a regulation portion taken along line IX-IX in Fig. 8.
Fig. 10 is a cross-sectional view of the regulation portion taken along line X-X in Fig. 8.
Fig. 11 is a side view of the electromagnetic shield provided in the connection jig.
Fig. 12 is a diagram illustrating the connection jig according to the second embodiment in a state where the electromagnetic shield is removed.
Fig. 13 is a diagram illustrating a connection jig according to another embodiment.
Fig. 14 is a diagram illustrating a connection jig according to another embodiment as viewed from a regulation portion side.

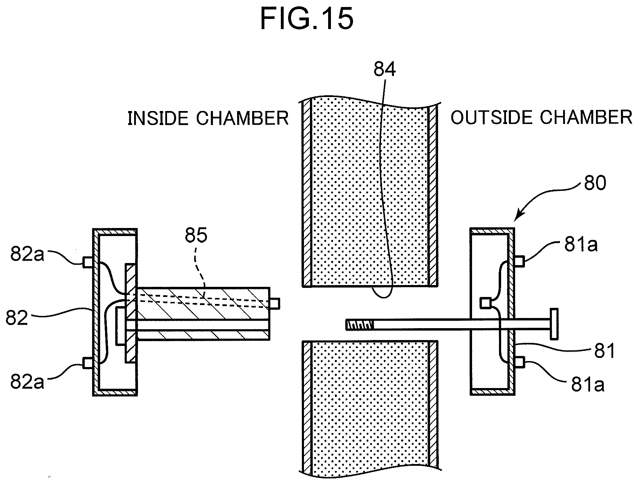

Fig. 15 is a diagram illustrating a conventional cable connection jig.

### Description of Embodiments

Hereinafter, embodiments of the present invention will be described in detail with reference to the drawings.

A withstand voltage test device according to the present embodiment is a test device for applying a high voltage to a test piece such as an electric component to check whether the test piece does not cause dielectric breakdown. That is, the test piece includes an insulating portion, and the withstand voltage test device is used to evaluate the withstand voltage of the insulating portion.

### (First Embodiment)

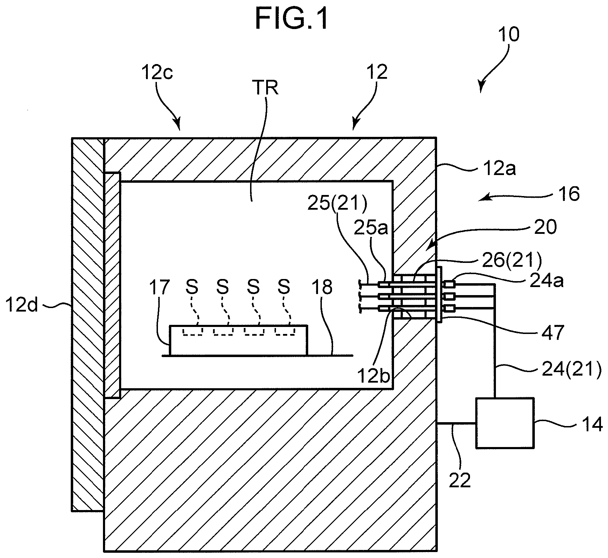

As illustrated in Fig. 1, the withstand voltage test device 10 includes a test chamber 12, a connection jig 20, and a power supply unit 14. The test chamber 12 includes a test room TR in which a plurality of test pieces S can be disposed. The connection jig 20 is applied to a cable hole 12b which is an example of a hole formed in a wall body 12a that defines the test room TR in the test chamber 12. The power supply unit 14 generates a voltage to be applied to the test piece S disposed in the test room TR. The test chamber 12 and the connection jig 20 constitute a chamber-with-jig 16. Note that, in the example of Fig. 1, a fixing member 17 on which the plurality of test pieces S are disposed is installed on a shelf board 18 in the test room TR, but the fixing member 17 can be omitted. The test piece S may be immersed in an insulating liquid stored in a box made of an electrically insulating material.

The test chamber 12 includes a chamber main body 12c having an open front surface and forming the test room TR, and a door 12d that opens and closes the front opening of the chamber main body 12c.

The test chamber 12 may be any type of chamber as long as it has the test room TR. In the present embodiment, the test chamber 12 is configured by a chamber capable of setting the inside of the test room TR to, for example, a temperature environment of 100°C or higher or a negative temperature environment. Furthermore, the test chamber 12 may be a chamber used in the case of causing a predetermined reaction in a test piece placed in a room temperature environment. In this case, even if gas that is not preferable to leak to the outside, such as ozone, is generated from the test piece, the gas can be prevented from leaking from the test room TR.

The power supply unit 14 is configured to generate at least one of a DC voltage and an AC voltage of, for example, 10 kV or more. A first conductive member 21 is connected to one connection end of the power supply unit 14, and a second conductive member 22 is connected to the other connection end. The first conductive member 21 and the second conductive member 22 are electrically connected to the test piece S. As a result, a closed circuit is formed between the power supply unit 14 and the test piece S. In a case where the power supply unit 14 generates at least one of the DC voltage and the AC voltage, no current flows through the closed circuit in a case where the insulating portion of the test piece S functions normally, but a current flows through the closed circuit when the test piece S undergoes dielectric breakdown. Therefore, it is possible to test the withstand voltage of the test piece S by monitoring the presence or absence of current with an ammeter (not illustrated).

The cable hole 12b is formed in a wall body 12a that defines the test room TR in the chamber main body 12c (test chamber 12). Note that Fig. 1 illustrates the cable hole 12b formed in a back wall of the chamber main body 12c, and the first conductive member 21 is inserted into the cable hole 12b. The second conductive member 22 is inserted into a cable hole (not illustrated) formed in a side wall of the chamber main body 12c. Note that the cable hole 12b through which the first conductive member 21 is inserted and the cable hole through which the second conductive member 22 is inserted are not limited to these positions.

The first conductive member 21 includes an external wiring 24, an in-chamber wiring 25, and a conductor 26. The external wiring 24 is a wiring that is connected to the power supply unit 14 and receives a voltage generated by the power supply unit 14, and is provided outside the chamber 12. The external wiring 24 is made of a shield wire having a core wire, an insulating material, a shield, and a covering.

A plurality of the external wirings 24 are connected to the power supply unit 14. In each of the external wirings 24, an external connector 24a connectable to an outer connection portion 26b of the conductor 26 to be described later is provided at a distal end portion on a side opposite to the power supply unit 14. Since the withstand voltage test device 10 has a configuration capable of applying a high voltage to a plurality of test pieces S at a time, the plurality of external wirings 24 are connected in parallel to the power supply unit 14. Note that the withstand voltage test device 10 is not limited to one that tests a plurality of test pieces S at a time, and may be configured to test one test piece S.

The in-chamber wiring 25 is a wiring disposed in the test room TR, and is electrically connected to the test piece S. The in-chamber wiring 25 is made of a wire material having a core wire and a covering. Note that the in-chamber wiring 25 may also be formed of a shield wire.

A plurality of the in-chamber wirings 25 are provided. An internal connector 25a is provided at one end of each in-chamber wiring 25. The internal connector 25a can be connected to a first connector portion 40 provided in a holding portion 28 described later. The other end of each in-chamber wiring 25 is electrically connected to the test piece S.

The conductor 26 is used to electrically connect the plurality of external wirings 24 and the plurality of in-chamber wirings 25. The conductor 26 is a component of the connection jig 20 inserted into the cable hole 12b. The connection jig 20 is a jig for electrically connecting the external wiring 24 and the in-chamber wiring 25 to each other through the cable hole 12b. The connection jig 20 is disposed so as to close the cable hole 12b so that air (steam or gas in some cases) in the test room TR does not leak out of the test room TR through the cable hole 12b.

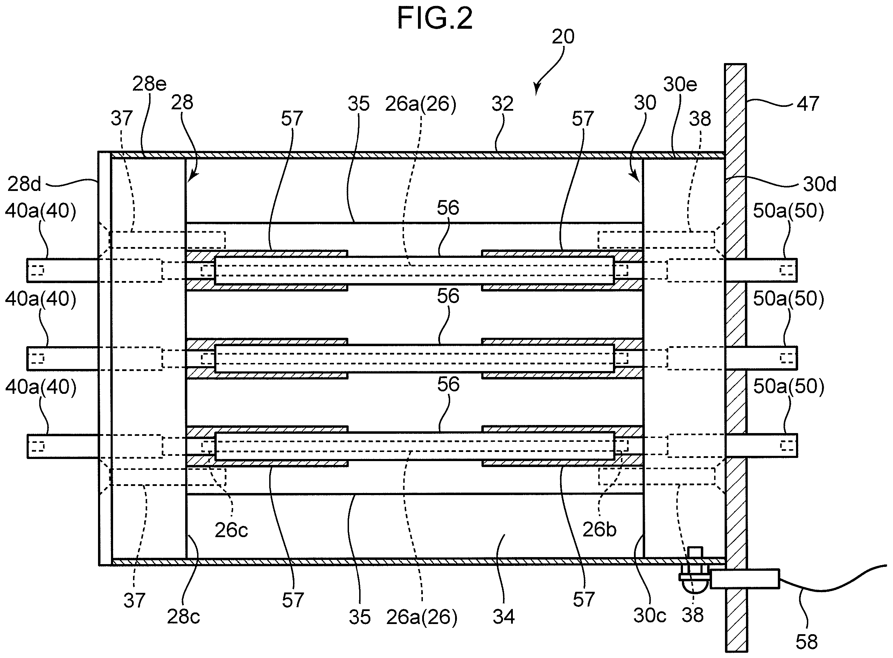

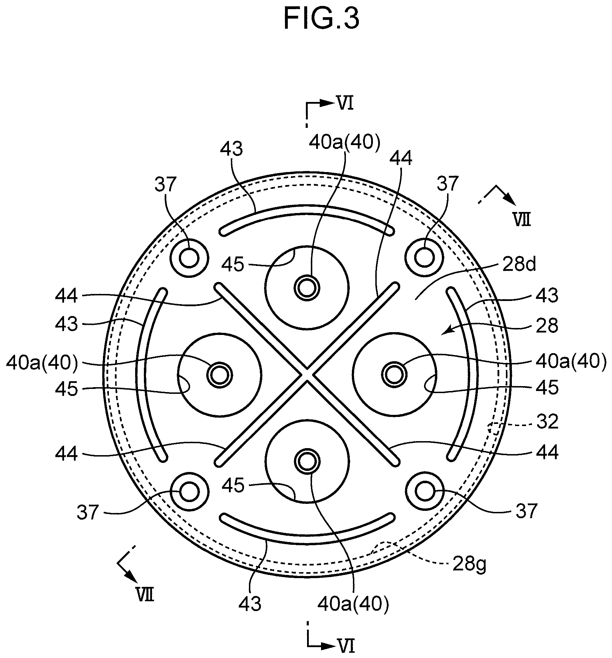

As illustrated in Figs. 2 and 3, the connection jig 20 includes the conductor 26, the holding portion 28, a regulation portion 30, and an electromagnetic shield 32. The holding portion 28 is disposed at an end portion of the cable hole 12b on the test room TR side (inner end portion of the cable hole 12b), and the regulation portion 30 is disposed at an end portion of the cable hole 12b on the chamber outer side (outer end portion of the cable hole 12b). That is, the regulation portion 30 is disposed at a position spaced apart from the holding portion 28. Therefore, a space is formed between the holding portion 28 and the regulation portion 30, and the electromagnetic shield 32 is disposed so as to define the outer peripheral portion of this space. A space defined by the electromagnetic shield 32 between the holding portion 28 and the regulation portion 30 is hereinafter referred to as a gap space 34.

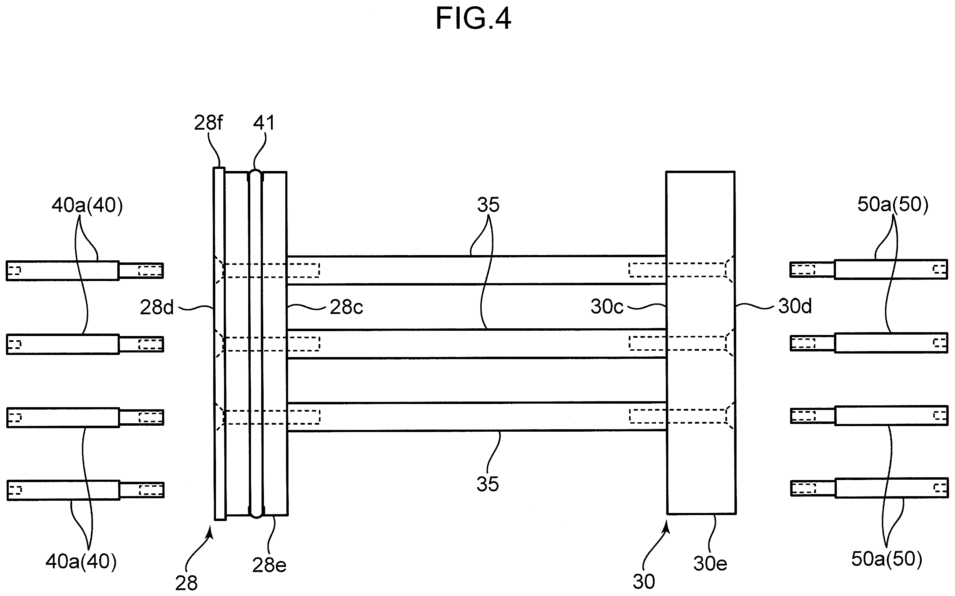

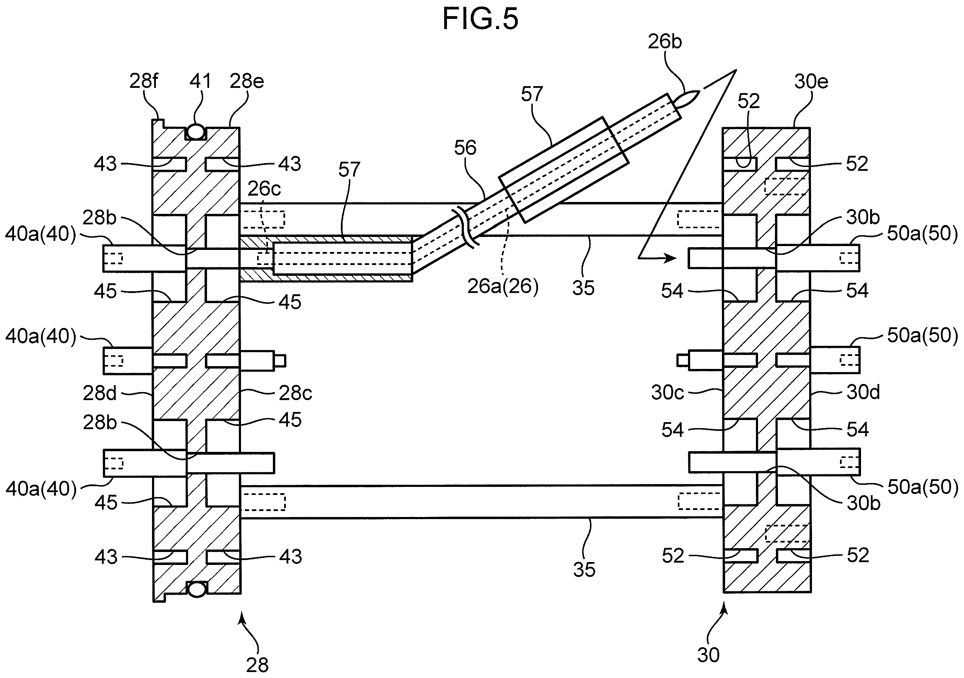

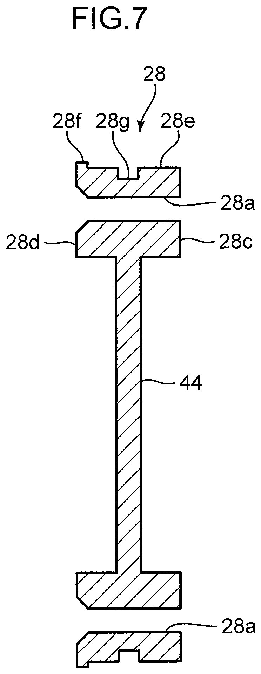

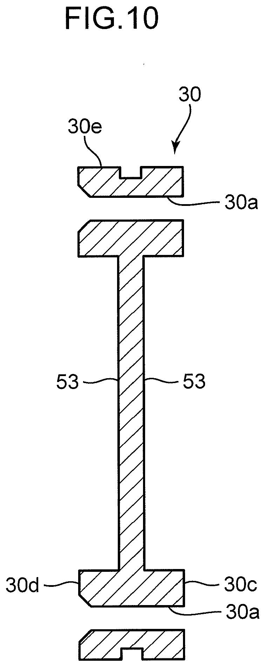

As also illustrated in Figs. 4 and 5, the holding portion 28 and the regulation portion 30 are coupled by a coupling rod 35. The coupling rod 35 is made of an electrically insulating material. The coupling rod 35 is disposed such that one end surface is in contact with the holding portion 28 and the other end surface is in contact with the regulation portion 30. The coupling rod 35 is fastened to the holding portion 28 by a fastener 37 (see Fig. 2) inserted through an insertion hole 28a (see Fig. 7) formed in the holding portion 28, and is fastened to the regulation portion 30 by a fastener 38 (see Fig. 2) inserted through an insertion hole 30a (see Fig. 10) formed in the regulation portion 30. By disposing the coupling rod 35 between the holding portion 28 and the regulation portion 30, the interval between the holding portion 28 and the regulation portion 30 is set to a predetermined width. Note that a plurality of the coupling rods 35 may be disposed at intervals in the circumferential direction in the vicinity of the outer peripheral portion of the holding portion 28 and the regulation portion 30, but alternatively, one coupling rod 35 may be disposed at the central portion of the holding portion 28 and the regulation portion 30.

As illustrated in Figs. 3 to 7, the holding portion 28 is formed in a circular plate shape corresponding to the cross-sectional shape of the cable hole 12b, and is made of or constituted of an electrically insulating material. The holding portion 28 is disposed such that one principal surface (a surface facing the gap space 34 or a space-side principal surface 28c) is located in the cable hole 12b. The other principal surface (a surface facing an opposite side of the gap space 34 or an opposite-side principal surface 28d) may be disposed so as to be flush with the inner end of the cable hole 12b, or may be disposed at a position protruding toward the test room TR more than the inner end of the cable hole 12b. Therefore, the holding portion 28 has a portion located in the space inside the electromagnetic shield 32.

The holding portion 28 holds the connector portion (first connector portion 40). The first connector portion 40 includes a plurality of connectors (first connectors 40a) corresponding to a plurality of conductive members 26a to be described later.

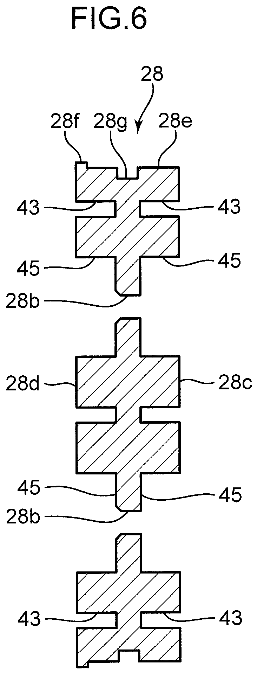

A plurality of holding holes 28b (see Fig. 6) penetrate the holding portion 28 in the thickness direction, and the first connector 40a is inserted into each of the holding holes 28b. Each of the first connectors 40a protrudes from the space-side principal surface 28c of the holding portion 28 and also protrudes from the opposite-side principal surface 28d.

The internal connector 25a (see Fig. 1) of the in-chamber wiring 25 is detachably connected to an inner end of the first connector 40a, which is an end on the test room TR side. On the other hand, a conductive member 26a, which will be described later, constituting the conductor 26 is connected to an outer end portion of the first connector 40a which is an end portion in the cable hole 12b. By connecting the conductive member 26a to the first connector 40a, the position of the portion of the conductive member 26a on the inner end portion side is held at a predetermined position.

The plurality of first connectors 40a are disposed concentrically with the electromagnetic shield 32 and at equal intervals in the circumferential direction. That is, the plurality of first connectors 40a are disposed at equal intervals in the circumferential direction so that the intervals between the adjacent first connectors 40a are the same. Furthermore, the plurality of first connectors 40a are disposed concentrically with the electromagnetic shield 32 so as to be located at equal distances from the electromagnetic shield 32.

As illustrated in Figs. 6 and 7, an outer peripheral surface 28e of the holding portion 28 is provided with a ridge 28f on which one axial end surface of the electromagnetic shield 32 abuts. The ridge 28f extends in the circumferential direction over the entire outer peripheral surface 28e of the holding portion 28 in the circumferential direction. The electromagnetic shield 32 is in contact with the side surface of the ridge 28f. As a result, the electromagnetic shield 32 is prevented from protruding toward the test room TR with respect to the holding portion 28, and the axial position of the electromagnetic shield 32 with respect to the holding portion 28 is determined.

An outer peripheral groove 28g extending in the circumferential direction over the entire circumferential direction is formed on the outer peripheral surface 28e of the holding portion 28. A sealing member 41 (see Fig. 4) in contact with the inner peripheral surface of the electromagnetic shield 32 is fitted into the outer peripheral groove 28g.

The sealing member 41 airtightly closes a space between the holding portion 28 and the electromagnetic shield 32, and is formed of, for example, an O-ring. By providing the sealing member 41, it is possible to prevent air (optionally steam or gas) in the test room TR from leaking from the gap between the holding portion 28 and the electromagnetic shield 32 into the gap space 34 (space inside the electromagnetic shield 32). Furthermore, since it is possible to suppress adhesion of water droplets and foreign substances contained in gas to the space-side principal surfaces 28c and 30c of the holding portion 28 and the regulation portion 30, it is possible to suppress occurrence of discharge via these substances.

Note that the sealing member 41 is not limited to the O-ring, and may be configured by a silicon seal or the like disposed to fill the outer peripheral groove 28g. Furthermore, if the electromagnetic shield 32 is in airtight contact with the outer peripheral surface 28e of the holding portion 28, the sealing member 41 can be omitted.

As illustrated in Figs. 3 and 6, unevenness is formed on a surface of the holding portion 28 with which the first connector portion 40 comes into contact. Note that the unevenness can be omitted.

Specifically, the plurality of first connectors 40a held by the holding portion 28 are provided so as to protrude from the space-side principal surface 28c and the opposite-side principal surface 28d of the holding portion 28, respectively, and are in contact with the space-side principal surface 28c and the opposite-side principal surface 28d (see Fig. 2). Furthermore, the electromagnetic shield 32 is in contact with the outer peripheral surface 28e of the holding portion 28. On the space-side principal surface 28c and the opposite-side principal surface 28d, between the first connector 40a (or the holding hole 28b) and the outer peripheral surface 28e, a recess (circumferential recess 43), which is a type of unevenness, is formed so as to extend in the circumferential direction. Therefore, in the space-side principal surface 28c and the opposite-side principal surface 28d, the creepage distance between the first connector 40a and the electromagnetic shield 32 is increased.

Note that the circumferential recess 43 may be formed in an arc shape concentric with the outer peripheral surface 28e, or may be formed to extend over the entire circumferential direction. Furthermore, in order to increase the creepage distance, a protrusion (circumferential protrusion) may be provided instead of the circumferential recess 43, or unevenness may be provided.

On the space-side principal surface 28c and the opposite-side principal surface 28d, as illustrated in Figs. 3 and 7, between the adjacent first connectors 40a, a recess (radial recess 44), which is a type of unevenness, is formed so as to extend in the radial direction. Therefore, in the space-side principal surface 28c and the opposite-side principal surface 28d, the creepage distance between the adjacent first connectors 40a is increased.

Note that, in order to increase the creepage distance, a protrusion (radial protrusion) may be provided instead of the radial recess 44, or unevenness may be provided.

On the space-side principal surface 28c and the opposite-side principal surface 28d, as illustrated in Figs. 3 and 6, a recess (peripheral recess 45), which is a type of unevenness, is formed around the holding hole 28b. That is, unevenness is formed on the surface of the holding portion 28 with which the first connector 40a comes into contact. Therefore, the creepage distance is increased on the space-side principal surface 28c and the opposite-side principal surface 28d.

Note that, in order to increase the creepage distance, a protrusion (peripheral protrusion) may be provided instead of peripheral recess 45, or unevenness may be provided.

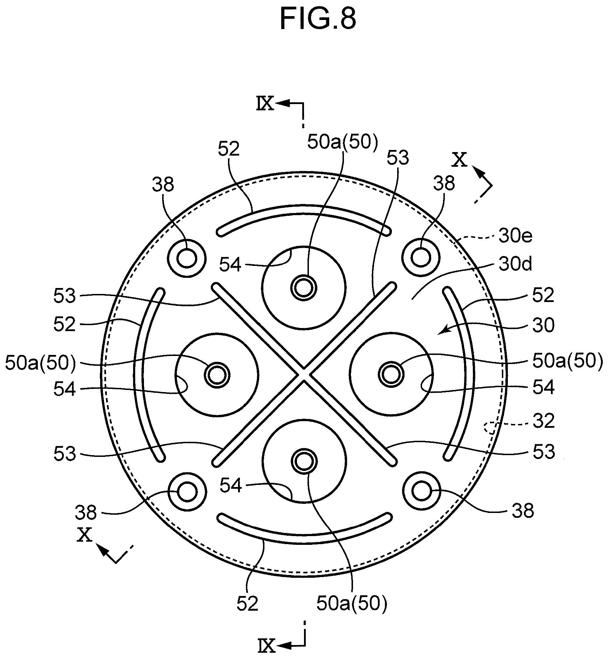

The regulation portion 30 is disposed at a position spaced apart from the holding portion 28 in the longitudinal direction of the conductor 26. As illustrated in Figs. 8 to 10, the regulation portion 30 is formed in a circular plate shape having the same diameter as the holding portion 28 and is made of or constituted of an electrically insulating material. The regulation portion 30 is disposed such that one principal surface (the surface facing the gap space 34 or the space-side principal surface 30c) is located in the cable hole 12b. The other principal surface (a surface facing an opposite side of the gap space 34 or an opposite-side principal surface 30d) of the regulation portion 30 may be disposed so as to be flush with the outer end of the cable hole 12b, or may be disposed at a position protruding outward (outward of the test chamber 12) from the outer end of the cable hole 12b. Therefore, the regulation portion 30 has a portion located in the space inside the electromagnetic shield 32.

As illustrated in Fig. 2, a stop plate 47 is fastened to the regulation portion 30, and the stop plate 47 is fixed to the wall body 12a of the chamber main body 12c (test chamber 12) that defines the test room TR. As a result, the connection jig 20 is fixed to the test chamber 12 in a posture in which the regulation portion 30 is positioned on the opposite side to the test room TR with respect to the holding portion 28.

As illustrated in Figs. 2 and 8, a connector portion (second connector portion 50) is fixed to the regulation portion 30. The second connector portion 50 includes a plurality of connectors (second connectors 50a) corresponding to a plurality of conductive members 26a to be described later.

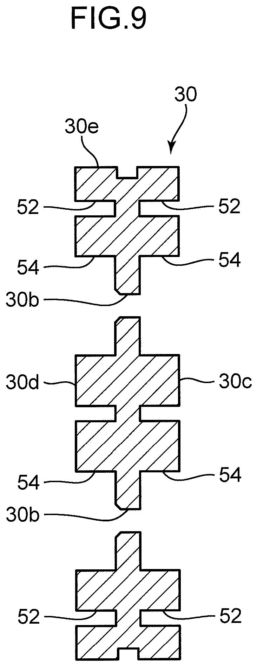

A plurality of regulation holes 30b (see Fig. 9) penetrate the regulation portion 30 in the thickness direction, and the second connector 50a is inserted into each of the regulation holes 30b. Each of the second connectors 50a protrudes from the space-side principal surface 30c of the regulation portion 30 and also protrudes from the opposite-side principal surface 30d.

An external connector 24a (see Fig. 1) of the external wiring 24 is detachably connected to an outer end of the second connector 50a. On the other hand, a conductive member 26a, which will be described later, constituting the conductor 26 is connected to an inner end portion of the second connector 50a which is an end portion in the cable hole 12b. By connecting the conductive member 26a to the second connector 50a, the position of the portion of the conductive member 26a on the outer end side is regulated.

The plurality of second connectors 50a are disposed concentrically with the electromagnetic shield 32 and at equal intervals in the circumferential direction. That is, the plurality of second connectors 50a are disposed at equal intervals in the circumferential direction so that the intervals between the adjacent second connectors 50a are the same. Furthermore, the plurality of second connectors 50a are disposed concentrically with the electromagnetic shield 32 so as to be located at equal distances from the electromagnetic shield 32.

Similarly to the holding portion 28, unevenness is formed on the surface of the regulation portion 30. Note that the unevenness can be omitted.

Specifically, the plurality of second connectors 50a fixed to the regulation portion 30 are provided so as to protrude from the space-side principal surface 30c and the opposite-side principal surface 30d of the regulation portion 30, and are in contact with the space-side principal surface 30c and the opposite-side principal surface 30d, respectively. Furthermore, the electromagnetic shield 32 is in contact with an outer peripheral surface 30e of the regulation portion 30. As illustrated in Figs. 8 and 9, on the space-side principal surface 30c and the opposite-side principal surface 30d, between the second connector 50a (or the regulation hole 30b) and the outer peripheral surface 30e, a recess (circumferential recess 52), which is a type of unevenness, is formed so as to extend in the circumferential direction. Therefore, in the space-side principal surface 30c and the opposite-side principal surface 30d, the creepage distance between the second connector 50a and the electromagnetic shield 32 is increased.

Note that the circumferential recess 52 may be formed in an arc shape concentric with the outer peripheral surface 30e, or may be formed to extend over the entire circumferential direction. Furthermore, in order to increase the creepage distance, a protrusion (circumferential protrusion) may be provided instead of the circumferential recess 52, or unevenness may be provided.

On the space-side principal surface 30c and the opposite-side principal surface 30d, as illustrated in Figs. 8 and 10, between the adjacent second connectors 50a, a recess (radial recess 53), which is a type of unevenness, is formed so as to extend in the radial direction. Therefore, in the space-side principal surface 30c and the opposite-side principal surface 30d, the creepage distance between the adjacent second connectors 50a is increased.

Note that, in order to increase the creepage distance, a protrusion (radial protrusion) may be provided instead of the radial recess 53, or unevenness may be provided.

On the space-side principal surface 30c and the opposite-side principal surface 30d, as illustrated in Figs. 8 and 9, a recess (peripheral recess 54), which is a type of unevenness, is formed around the regulation hole 30b. That is, unevenness is formed on the surface of the regulation portion 30 with which the second connector 50a comes into contact. Therefore, the creepage distance is increased on the space-side principal surface 30c and the opposite-side principal surface 30d.

Note that, in order to increase the creepage distance, a protrusion (peripheral protrusion) may be provided instead of peripheral recess 54, or unevenness may be provided.

The conductor 26 is a conductor for electrically connecting the external wiring 24 and the in-chamber wiring 25 to each other. The conductor 26 includes a plurality of conductive members 26a (see Fig. 5), and each conductive member 26a is made of a metal conductor such as a flexible metal wire material or a non-flexible metal rod. One end portion (outer end portion) of each conductive member 26a is provided with an outer connection portion 26b (see Fig. 5) connected to the second connector 50a provided in the regulation portion 30. Furthermore, an inner connection portion 26c (see Fig. 5) connected to the first connector 40a provided in the holding portion 28 is provided at the other end (inner end) of each conductive member 26a.

Each conductive member 26a is disposed in a space (gap space 34) between the holding portion 28 and the regulation portion 30. That is, the conductor 26 has a portion disposed in the space inside the electromagnetic shield 32. The plurality of conductive members 26a are disposed concentrically with the electromagnetic shield 32 and at equal intervals in the circumferential direction of the electromagnetic shield 32.

Note that, as understood from Figs. 2 to 4, four conductive members 26a are provided, but the number of conductive members 26a is not limited thereto. Note that the number of the first connectors 40a of the holding portion 28 and the number of the second connectors 50a of the regulation portion 30 correspond to the number of the conductive members 26a, and the number of the first connectors 40a and the number of the second connectors 50a can also be changed according to the number of the conductive members 26a.

Each of the conductive members 26a is provided with an insulating coating 56 (see Fig. 5). Therefore, since the insulator is interposed between the adjacent conductive members 26a, it is possible to prevent generation of aerial discharge between the adjacent conductive members 26a. Furthermore, each of the conductive members 26a may be provided with a second insulating coating 57 harder than the insulating coating 56. As a result, deformation of each conductive member 26a can be further suppressed. Note that the second insulating coating 57 can be omitted.

Similarly to the holding portion 28, the regulation portion 30 may be provided with an outer peripheral groove (not illustrated) on the outer peripheral surface 30e, and a sealing member (not illustrated) may be fitted into the outer peripheral groove. The sealing member is in airtight contact with the electromagnetic shield 32. Furthermore, the electromagnetic shield 32 may be in airtight contact with the outer peripheral surface 30e of the regulation portion 30 without providing a sealing member.

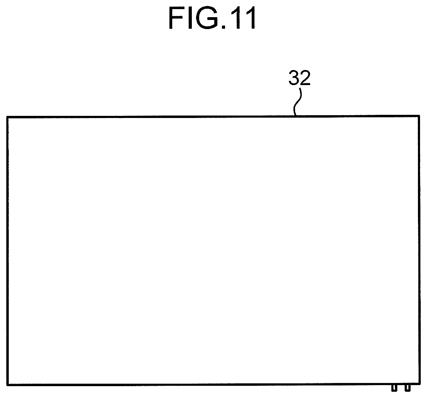

As also illustrated in Fig. 11, the electromagnetic shield 32 is formed in a tubular shape by a thin metal plate. The electromagnetic shield 32 has a shape conforming to the cross-sectional shape of the cable hole 12b. In the present embodiment, since the cable hole 12b is formed in a circular cross section, the electromagnetic shield 32 has a cylindrical shape. The electromagnetic shield 32 is disposed such that a direction in which the holding portion 28 and the regulation portion 30 are spaced apart from each other is an axial direction of the electromagnetic shield 32. In other words, the holding portion 28 is located at one end of the electromagnetic shield 32, and the regulation portion 30 is located at the other end of the electromagnetic shield 32.

The outer peripheral surface of the electromagnetic shield 32 is in airtight contact with the inner peripheral edge portion of the cable hole 12b over the entire circumferential direction. However, the electromagnetic shield 32 does not need to be in contact with the inner peripheral edge portion of the cable hole 12b over the entire outer peripheral surface in the axial direction, and may be in contact with the inner peripheral edge portion of the cable hole 12b in at least a part in the axial direction. Since the electromagnetic shield 32 comes into contact with the cable hole 12b, air (steam or gas in some cases) in the test room TR is prevented from leaking to the outside through between the electromagnetic shield 32 and the inner peripheral edge portion of the cable hole 12b.

Note that, in the present embodiment, since the electromagnetic shield 32 is provided for the purpose of preventing leakage of noise and also for the purpose of preventing leakage of air or the like, it is in airtight contact with the inner peripheral edge portion of the cable hole 12b. However, in a case where prevention of leakage of air or the like is not important, the electromagnetic shield 32 does not need to be in airtight contact with the inner peripheral edge portion of the cable hole 12b. In this case, the electromagnetic shield 32 may be formed in a cylindrical shape by a net-like member.

A shield line 58 (see Fig. 2) is connected to the electromagnetic shield 32, and in a case where the electromagnetic shield 32 is charged, charges can be released through the shield line 58.

As described above, in the connection jig 20 according to the present embodiment, the periphery of the conductor 26 is electromagnetically shielded by the electromagnetic shield 32 in the space (gap space 34) between the holding portion 28 and the regulation portion 30. Therefore, even when a high voltage is applied to the conductor 26, it is possible to prevent noise generated from the conductor 26 from leaking to the outside of the holding portion 28, the regulation portion 30, and the electromagnetic shield 32. In addition, since the position of the conductor 26 with respect to the electromagnetic shield 32 is regulated by the holding portion 28 and the regulation portion 30, it is possible to suppress occurrence of aerial discharge between the conductor 26 and the electromagnetic shield 32. Furthermore, since the holding portion 28 and the regulation portion 30 are spaced apart from each other, a space (gap space 34) is formed between the holding portion 28 and the regulation portion 30. Therefore, the heat capacity of the jig can be reduced as compared with a jig made of an insulator having a shape filling the inside of the cable hole 12b. Therefore, when the connection jig 20 is used in the test chamber 12, it is possible to suppress the influence of the heat storage of the connection jig 20 on the temperature of the space in the test chamber 12.

Furthermore, in the connection jig 20 of the present embodiment, the plurality of conductive members 26a are disposed so as to be located at equal distances from the electromagnetic shield 32 by the plurality of first connectors 40a and the regulation portion 30. Therefore, it is possible to avoid a situation in which discharge easily occurs between any of the conductive members 26a and the electromagnetic shield 32.

Furthermore, in the connection jig 20 of the present embodiment, the plurality of conductive members 26a are disposed concentrically with the electromagnetic shield 32 and at equal intervals in the circumferential direction of the electromagnetic shield 32, and the distances between the conductive members 26a adjacent in the circumferential direction are equal. Therefore, it is possible to avoid a situation in which discharge is likely to occur between the adjacent conductive members 26a.

Furthermore, in the connection jig 20 of the present embodiment, unevenness is formed between the first connector portion 40 and the electromagnetic shield 32 on the space-side principal surface 28c and the opposite-side principal surface 28d of the holding portion 28 in contact with the first connector 40a. As a result, the creepage distance between the first connector portion 40 and the electromagnetic shield 32 can be made relatively long on the surface of the holding portion 28, and occurrence of creeping discharge can be suppressed.

Furthermore, in the connection jig 20 of the present embodiment, on the space-side principal surface 28c and the opposite-side principal surface 28d of the holding portion 28 with which the first connector 40a is in contact, unevenness is formed between the adjacent first connectors 40a. Therefore, on the space-side principal surface 28c and the opposite-side principal surface 28d of the holding portion 28, the creepage distance between the adjacent first connectors 40a can be made relatively long, and the occurrence of creeping discharge can be suppressed.

Furthermore, in the connection jig 20 of the present embodiment, unevenness is formed around the first connector portion 40 on the space-side principal surface 28c and the opposite-side principal surface 28d of the holding portion 28. Therefore, on the space-side principal surface 28c and the opposite-side principal surface 28d of the holding portion 28, the creepage distance around the first connector portion 40 can be made relatively long, and occurrence of creeping discharge can be suppressed.

Furthermore, in the connection jig 20, the chamber-with-jig 16, and the withstand voltage test device 10 according to the present embodiment, the holding portion 28 and the regulation portion 30 are spaced apart from each other, and a space (gap space 34) is formed between the holding portion 28 and the regulation portion 30. Therefore, the heat capacity of the jig can be reduced as compared with the case where the inside of the cable hole 12b is closed by the jig made of an insulator. This makes it possible to suppress the influence of the heat storage of the jig on the temperature of the space in the test chamber.

Furthermore, in the connection jig 20, the chamber-with-jig 16, and the withstand voltage test device 10 of the present embodiment, the sealing member 41 that closes between the holding portion 28 and the electromagnetic shield 32 is provided. Therefore, it is possible to prevent air (vapor or gas in some cases) in the test chamber 12 from entering the gap space 34 inside the electromagnetic shield 32. Furthermore, in a case where the inside of the test chamber 12 is heated to a high temperature, it is possible to prevent the conductor 26 from being exposed to a high temperature, and thus, it is possible to suppress generation of discharge from the conductor 26. Moreover, since the electromagnetic shield 32 is formed of a plate member, discharge from the conductor 26 to the electromagnetic shield 32 can be suppressed as compared with a case where the electromagnetic shield 32 is formed of a net-like member or the like.

Note that, in the present embodiment, the first connector 40a is configured to protrude from both the space-side principal surface 28c and the opposite-side principal surface 28d of the holding portion 28, but the present embodiment is not limited thereto. For example, the first connector 40a may be configured to only protrude from the opposite-side principal surface 28d of the holding portion 28 but not to protrude from the space-side principal surface 28c. In this case, the conductive member 26a is connected to the first connector 40a in the holding portion 28.

Furthermore, in the present embodiment, the second connector 50a is configured to protrude from both the space-side principal surface 30c and the opposite-side principal surface 30d of the regulation portion 30, but the present embodiment is not limited thereto. For example, the second connector 50a may be configured to only protrude from the opposite-side principal surface 30d of the regulation portion 30 but not to protrude from the space-side principal surface 30c. In this case, the conductive member 26a is connected to the second connector 50a in the regulation portion 30.

### (Second Embodiment)

In the first embodiment, the second connector portion 50 is fixed to the regulation portion 30, and the conductor 26 (the plurality of conductive members 26a) is connected to the second connector portion 50, whereby the position of the outer portion of the conductor 26 (the plurality of conductive members 26a) is regulated. That is, the conductor 26 (the plurality of conductive members 26a) is provided separately from the external wiring 24.

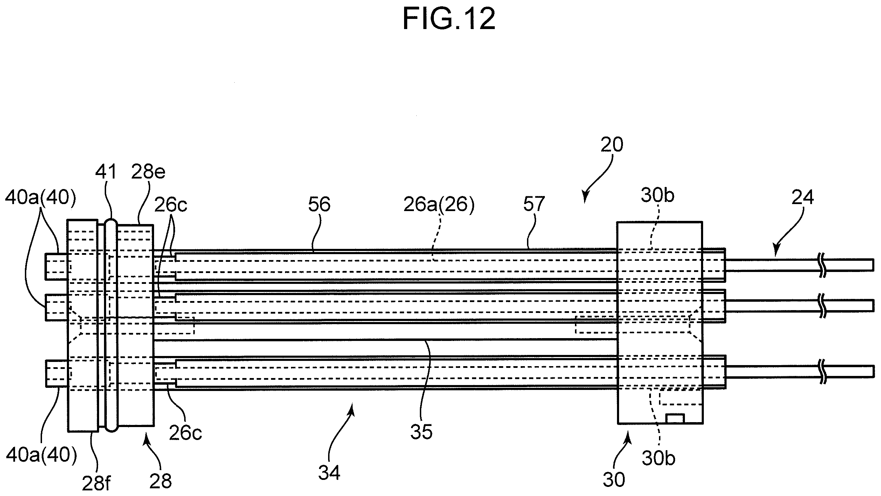

In contrast, in the second embodiment, the second connector portion 50 is not provided in the regulation portion 30. As illustrated in Fig. 12, the conductor 26 (the plurality of conductive members 26a) is inserted into the regulation hole 30b of the regulation portion 30 and is drawn outward through the regulation portion 30. Note that here, the same components as those of the first embodiment are denoted by the same reference numerals, and a detailed description thereof will be omitted.

The regulation hole 30b may have an inner diameter larger than that of the regulation hole 30b of the regulation portion 30 in the first embodiment. In this case, each conductive member 26a (in a case where the insulating coating 56 and the second insulating coating 57 are applied, they are also included) may not be in contact with the inner peripheral surface of the regulation hole 30b, but even in this case, the position of each conductive member 26a (conductor 26) in the regulation hole 30b is regulated by the regulation hole 30b. Therefore, it is possible to suppress generation of aerial discharge between each conductive member 26a (conductor 26) and the electromagnetic shield 32.

The inner connection portion 26c connected to the first connector 40a provided in the holding portion 28 is provided at an inner end portion of the conductive member 26a. On the other hand, the conductive member 26a passes through the regulation hole 30b of the regulation portion 30 and is drawn out from the gap space 34 to the outside. That is, the conductive member 26a (conductor 26) passes through the regulation portion 30 and is drawn outward. The conductive member 26a (conductor 26) constitutes at least a part of the external wiring 24. Therefore, the outer end portion of the conductive member 26a (conductor 26) may be directly connected to the power supply unit 14.

In the second embodiment, by pulling the conductive member 26a from the outside of the connection jig 20, the inner connection portion 26c can be removed from the first connector 40a of the holding portion 28.

Note that, although descriptions of other configurations, operations, and effects are omitted, the description of the first embodiment can be applied to the description of the second embodiment.

### (Other Embodiments)

Note that it should be understood that the embodiment disclosed herein is illustrative in all respects and is not restrictive. The present invention is not limited to the above embodiments, and various modifications, improvements, and the like can be made without departing from the gist of the present invention.

For example, in the above embodiment, since the cable hole 12b is formed in a circular cross section, the holding portion 28 and the regulation portion 30 are formed in a circular disk shape, and the electromagnetic shield 32 is formed in a cylindrical shape. However, the present embodiment is not limited thereto. If the cable hole 12b has a shape other than the circular cross section, the holding portion 28 and the regulation portion 30 are formed in shapes corresponding thereto, and the electromagnetic shield 32 is also formed in a tubular shape having a cross section corresponding thereto. For example, if the cable hole 12b has a polygonal cross section, the holding portion 28 and the regulation portion 30 also have a polygonal shape, and the electromagnetic shield 32 also has a tubular cross section having a polygonal shape.

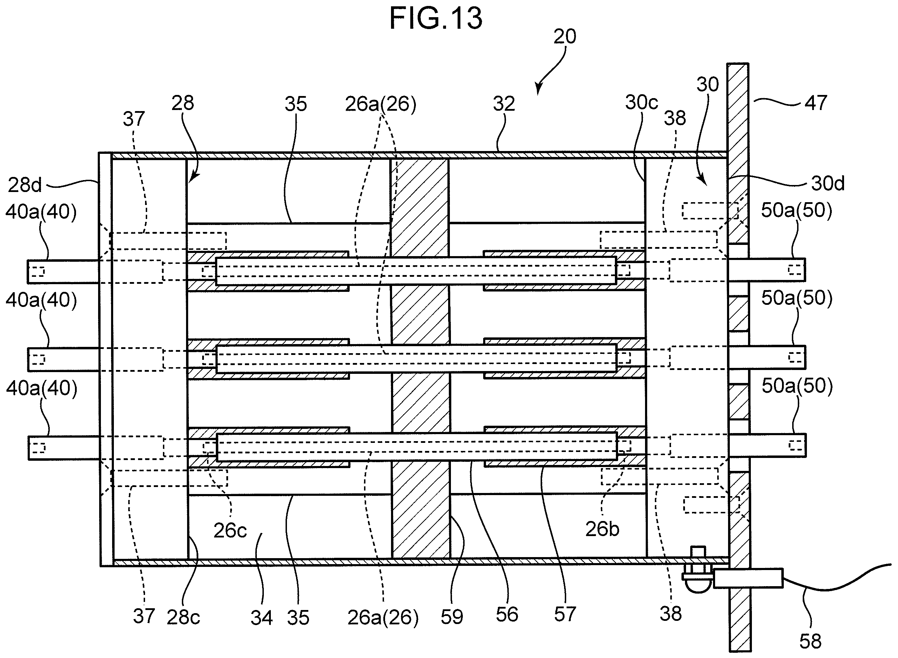

Furthermore, as illustrated in Fig. 13, a partition member 59 may be provided between the holding portion 28 and the regulation portion 30. The partition member 59 is provided to prevent air (optionally steam or gas) on the holding portion 28 side in the gap space 34 from flowing to the regulation portion 30 side. Therefore, similarly to the holding portion 28, a sealing member (not illustrated) is preferably provided on the outer peripheral surface of the partition member 59. Furthermore, by providing the partition member 59, the temperature on the side of the test room TR is less likely to be transmitted to the outside of the test room TR.

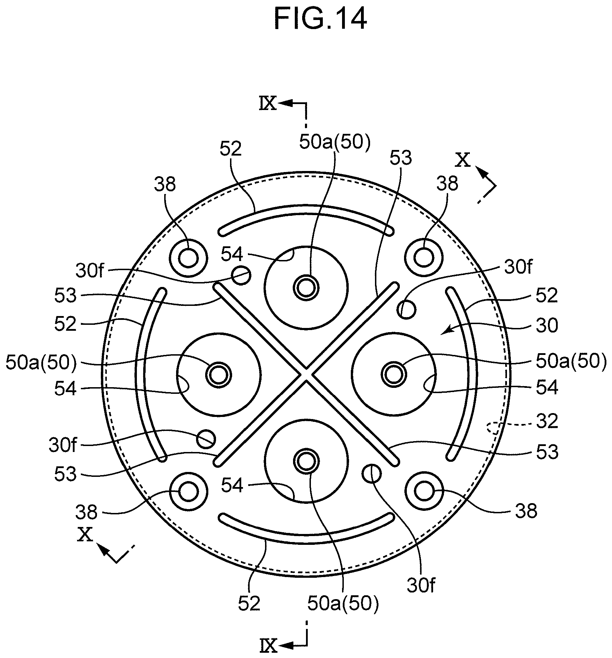

As illustrated in Fig. 14, a through hole 30f may be formed in the regulation portion 30 so that dry air can be supplied from a dry air supply source into the gap space 34. As a result, the amount of water vapor in the gap space 34 can be reduced, so that portions of the holding portion 28 and the regulation portion 30 facing the gap space 34 can be prevented from getting wet, and creeping discharge on a wet surface can be suppressed. Furthermore, the through hole 30f may be used to vacuum the inside of the gap space 34 by a pump (not illustrated) instead of being used to supply dry air. In a case where the through hole 30f is not used, a plug member (not illustrated) for closing the through hole 30f may be provided.

The insulating coating 56 of each conductive member 26a may be omitted. However, in this case, an insulating partition is provided between the conductive members 26a in order to prevent aerial discharge between the conductive members 26a. That is, an insulator is interposed between the conductive members 26a. The insulating partition may be disposed at the position of the radial recess 44 of the holding portion 28 illustrated in Fig. 3. Furthermore, in order to prevent aerial discharge between the conductive member 26a and the electromagnetic shield 32, an insulating partition is also provided between the conductive member 26a and the electromagnetic shield 32. That is, an insulator is interposed between the conductive member 26a and the electromagnetic shield 32. The insulating partition may be disposed at the position of the circumferential recess 43 of the holding portion 28 illustrated in Fig. 3. Furthermore, an insulating resin coating may be applied to the inner peripheral surface of the electromagnetic shield 32.

Here, the embodiment will be outlined.
(1) A connection jig according to the embodiment is a connection jig used in a test chamber, the connection jig including: a holding portion holding a connector portion and made of an electrically insulating material; a regulation portion disposed at a position spaced apart from the holding portion and made of an electrically insulating material; an electromagnetic shield having a size conforming to a hole formed in a wall body of the test chamber and disposed so as to cover a space between the holding portion and the regulation portion; and a conductor connected to the connector portion and including a portion disposed in the space. The conductor is connected to a connector portion fixed to the regulation portion, or is drawn out to an outside of the regulation portion through the regulation portion in a state where a position of the conductor with respect to the electromagnetic shield is regulated.

In the connection jig, the periphery of the conductor is electromagnetically shielded by the electromagnetic shield in the space between the holding portion and the regulation portion. Therefore, even when a high voltage is applied to the conductor, it is possible to prevent noise generated from the conductor from leaking to the outside of the holding portion, the regulation portion, and the electromagnetic shield. In addition, since the position of the conductor with respect to the electromagnetic shield is regulated by the holding portion and the regulation portion, it is possible to suppress occurrence of aerial discharge between the conductor and the electromagnetic shield. Furthermore, since the holding portion and the regulation portion are spaced apart from each other, a space is formed between the holding portion and the regulation portion. Therefore, the heat capacity of the connection jig can be reduced as compared with a jig made of an insulator having a shape filling the hole of the test chamber. Therefore, when the connection jig is used in the test chamber, it is possible to suppress the influence of the heat storage of the connection jig on the temperature of the space in the test chamber.

(2) The conductor may include a plurality of conductive members, and the connector portion of the holding portion may include a plurality of connectors corresponding to the plurality of conductive members. In this case, the plurality of conductive members may be disposed so as to be located at equal distances from the electromagnetic shield by the plurality of connectors and the regulation portion.

In this aspect, since the plurality of conductive members are disposed at equal distances from the electromagnetic shield, it is possible to avoid a situation in which discharge easily occurs between any of the conductive members and the electromagnetic shield.

(3) The electromagnetic shield may be formed in a cylindrical shape, and a number of the plurality of conductive members may be three or more. In this case, the plurality of conductive members may be disposed concentrically with the electromagnetic shield and at equal intervals in a circumferential direction of the electromagnetic shield.

In this aspect, since the distances between the conductive members adjacent in the circumferential direction are equal to each other, it is possible to avoid a situation in which discharge is likely to occur between the adjacent conductive members. Furthermore, since the plurality of conductive members are disposed concentrically with the electromagnetic shield, it is possible to avoid a situation in which discharge easily occurs between any of the conductive members and the electromagnetic shield.

(4) The connector portion held by the holding portion and the electromagnetic shield may be in contact with a surface of the holding portion. In this case, unevenness may be formed on the surface of the holding portion between the connector portion and the electromagnetic shield.

In this aspect, since a creepage distance between the connector portion and the electromagnetic shield can be made relatively long on the surface of the holding portion, occurrence of creeping discharge can be suppressed.

(5) Each of the plurality of connectors may be in contact with a surface of the holding portion. In this case, unevenness may be formed on the surface of the holding portion between adjacent connectors among the plurality of connectors.

In this aspect, since a creepage distance between the adjacent connectors can be made relatively long on the surface of the holding portion, occurrence of creeping discharge can be suppressed.

(6) The connector portion held by the holding portion may be in contact with a surface of the holding portion. In this case, unevenness may be formed around the connector portion on the surface of the holding portion.

In this aspect, since a creepage distance around the connector portion can be made relatively long on the surface of the holding portion, occurrence of creeping discharge can be suppressed.

(7) The electromagnetic shield may have a tubular shape with a direction in which the holding portion and the regulation portion are spaced apart from each other as an axial direction, and may define an outer peripheral portion of the space between the holding portion and the regulation portion.

(8) A chamber-with-jig according to the embodiment includes the connection jig and a test chamber, wherein a hole into which an electromagnetic shield of the connection jig is inserted is formed in a wall body of the test chamber.

In the chamber-with-jig, since the periphery of the conductor is electromagnetically shielded by the electromagnetic shield, it is possible to prevent noise generated from the conductor from leaking to the outside of the test chamber even when a high voltage is applied to the conductor in a state where the connection jig is disposed in the hole of the wall body. In addition, since the position of the conductor with respect to the electromagnetic shield is regulated by the holding portion and the regulation portion, discharge between the conductor and the electromagnetic shield is suppressed. Furthermore, the holding portion and the regulation portion are spaced apart from each other, and a space is formed between the holding portion and the regulation portion. Therefore, the heat capacity of the connection jig can be reduced as compared with a case where a jig including an insulator having a shape that closes the hole of the wall body is used. Therefore, it is possible to suppress the influence of the heat storage of the connection jig on the temperature of the space in the test chamber.

(9) The connection jig may be disposed in a posture in which the holding portion is located inner side of the test chamber with respect to the regulation portion, and the electromagnetic shield may be formed of a plate member. In this case, the chamber-with-jig may further include a sealing member that closes between the holding portion and the electromagnetic shield.

In this aspect, air (in some cases, vapor or gas) in the test chamber can be prevented from entering a space inside the electromagnetic shield. Furthermore, in a case where the inside of the test chamber is heated to a high temperature, it is possible to prevent the conductor from being exposed to a high temperature, so that it is possible to suppress generation of discharge from the conductor. Furthermore, since the electromagnetic shield is formed of the plate member, it is possible to suppress discharge from the conductor to the electromagnetic shield as compared with a case where the electromagnetic shield is formed of a net-like member.

(10) A withstand voltage test device according to the embodiment includes the chamber-with-jig, and a power supply unit configured to be capable of applying a voltage to the conductor.

This application is based on Japanese Patent Application No. 2024-85407 filed with the Japan Patent Office on May 27, 2024, the contents of which are incorporated herein by reference.

## Claims

1. A connection jig (20) used in a test chamber (12), the connection jig (20) comprising:
a holding portion (28) holding a connector portion (40) and made of an electrically insulating material;
a regulation portion (30) disposed at a position spaced apart from the holding portion (28) and made of an electrically insulating material;
an electromagnetic shield (32) having a size conforming to a hole formed in a wall body of the test chamber (12) and disposed so as to cover a space (34) between the holding portion (28) and the regulation portion (30); and
a conductor (26) connected to the connector portion (40) and including a portion disposed in the space (34),
wherein the conductor (26) is connected to a connector portion (50) fixed to the regulation portion (30), or is drawn out to an outside of the regulation portion (30) through the regulation portion (30) in a state where a position of the conductor (26) with respect to the electromagnetic shield (32) is regulated.

2. The connection jig (20) according to claim 1, wherein
the conductor (26) includes a plurality of conductive members (26a),
the connector portion (40) of the holding portion (28) includes a plurality of connectors (40a) corresponding to the plurality of conductive members (26a), and
the plurality of conductive members (26a) are disposed so as to be located at equal distances from the electromagnetic shield (32) by the plurality of connectors (40a) and the regulation portion (30).

3. The connection jig (20) according to claim 2, wherein
the electromagnetic shield (32) is formed in a cylindrical shape,
a number of the plurality of conductive members (26a) is three or more, and
the plurality of conductive members (26a) are disposed concentrically with the electromagnetic shield (32) and at equal intervals in a circumferential direction of the electromagnetic shield (32).

4. The connection jig (20) according to claim 1, wherein
the connector portion (40) held by the holding portion (28) and the electromagnetic shield (32) are in contact with a surface of the holding portion (28), and
unevenness is formed on the surface of the holding portion (28) between the connector portion (40) and the electromagnetic shield (32).

5. The connection jig (20) according to claim 2, wherein
each of the plurality of connectors (40a) is in contact with a surface of the holding portion (28), and
unevenness is formed on the surface of the holding portion (28) between adjacent connectors among the plurality of connectors (40a).

6. The connection jig (20) according to claim 1, wherein
the connector portion (40) held by the holding portion (28) is in contact with a surface of the holding portion (28), and
unevenness is formed around the connector portion (40) on the surface of the holding portion (28).

7. The connection jig (20) according to claim 1, wherein the electromagnetic shield (32) has a tubular shape with a direction in which the holding portion (28) and the regulation portion (30) are spaced apart from each other as an axial direction, and defines an outer peripheral portion of the space (34) between the holding portion (28) and the regulation portion (30).

8. A chamber-with-jig (16), the chamber-with-jig (16) comprising:
the connection jig (20) according to any one of claims 1 to 7; and
a test chamber (12),
wherein a hole into which an electromagnetic shield (32) of the connection jig (20) is inserted is formed in a wall body of the test chamber (12).

9. The chamber-with-jig (16) according to claim 8, wherein
the connection jig (20) is disposed in a posture in which the holding portion (28) is located inner side of the test chamber (12) with respect to the regulation portion (30),
the electromagnetic shield (32) is formed of a plate member, and
the chamber-with-jig (16) further comprises a sealing member (41) that closes between the holding portion (28) and the electromagnetic shield (32).

10. A withstand voltage test device (10) comprising:
the chamber-with-jig (16) according to claim 8 or 9; and
a power supply unit (14) configured to be capable of applying a voltage to the conductor (26).
